# EUROPÄISCHE PATENTSCHRIFT

(11) **EP 3 460 593 B1**
(45) Veröffentlichungstag und Bekanntmachung des Hinweises auf die Patenterteilung: **30.06.2021**
(21) Anmeldenummer: 17192613.2
(22) Anmeldetag: 22.09.2017
(51) Int. Cl.: H02P 29/02, H02H 7/08, H02M 1/32, H02P 25/06

(54) **SICHERE SCHALTVORRICHTUNG**
SECURE SWITCHING DEVICE
DISPOSITIF DE COMMUTATION SÉCURISÉ

(43) Veröffentlichungstag der Anmeldung: 27.03.2019
(73) Patentinhaber: B&R Industrial Automation GmbH, 5142 Eggelsberg (AT)
(72) Erfinder: Klappauf, Christof, 83404 Ainring (DE); Schneider, Christian, 5122 Hochburg (AT); Winkler, Norbert, 5251 Höhnhart (AT)
(74) Vertreter: Patentanwälte Pinter & Weiss OG

(56) Entgegenhaltungen:
- EP-A2- 2 733 807
- WO-A1-2014/139549
- DE-A1- 10 307 999
- DE-A1-102015 102 236

## Beschreibung

Die gegenständliche Erfindung betrifft ein Verfahren und eine Schaltvorrichtung zum Schalten eines Signals auf einer Verbindung zwischen einem ersten Punkt und einem zweiten Punkt.

Im Zusammenhang mit elektrischen Antrieben finden die unterschiedlichsten Sicherheitsfunktionen Anwendung, deren Aufgabe darin besteht, die Risiken sowohl für Mensch als auch für die Maschinen selbst, zu reduzieren. Zu einer der gängigsten und grundlegendsten Sicherheitsfunktionen im Zusammenhang mit elektrischen Antrieben gehört die sichere Impulssperre. Im Allgemeinen wird die sichere Impulssperre als "Safe Torque Off Funktion" bzw. "STO-Funktion" bezeichnet, weshalb in diesem Zusammenhang in weiterer Folge nur noch die Bezeichnung STO-Funktion genutzt wird. Aufgabe einer STO-Funktion ist es einen elektrischen Antrieb drehmomentfrei zu schalten. Ziel ist es dabei, dass der elektrische Antrieb keinen Strom mehr erhält, welcher zu einer Drehbewegung führen kann. Die STO-Funktion sorgt somit dafür, dass an einem elektrischen Antrieb kein drehmomentbildender Strom mehr wirken kann und eine fortlaufende Drehbewegung oder auch ein ungewollter Anlauf verhindert wird. Selbstverständlich gilt dies auch in analoger Weise für den Antrieb mit Linearmotoren und deren Linearbewegung. In diesem Zusammenhang findet die STO-Funktion breite Anwendung beispielsweise in der Produktions- und Fördertechnik. Da eine Überwachung der Stillstandposition durch die übliche STO-Funktion selbst nicht erfolgt, wird die STO-Funktion üblicherweise realisiert, indem die Spannungsversorgung der Treiber deaktiviert wird. Diese Ausgestaltung wird in Anwendungen eingesetzt, bei denen der Antrieb durch das Lastmoment oder durch Reibung in ausreichend kurzer Zeit selbst zum Stillstand kommt oder das Ausdrehen des Antriebs keine sicherheitstechnische Relevanz hat. Sind zur Risikominderung keine entsprechenden Bremssysteme vorgesehen, läuft der elektrische Antrieb nach Aktivierung der STO-Funktion ungebremst aus.

Die AT 516568 B1 offenbart daher zur Realisierung einer STO-Funktion die Trennung eines PWM-Signals, welches die Leistungsschalter für die Übertragung eines Impulssignals ansteuert. Auf diese Weise wird nicht die Energieversorgung der Treiber der Leistungsschalter unterbrochen, sondern es wird das Impulssignal selbst gesperrt. Notwendige Energiespeicher bzw. Kondensatoren können kleiner dimensioniert werden als bei einer Unterbrechung der Treiberversorgung, da nur sehr wenig Energie für die Übertragung des Impulssignals benötigt wird und somit der zu speichernde Energieanteil geringer ist. Durch die Unterbrechung des Impulssignals kommt es somit zu geringeren zeitlichen Verzögerungen und zu einem wesentlich schnelleren Auslösen der Sicherheitsfunktion als bei Schaltungen nach dem Stand der Technik.

Zur Realisierung einer Sicherheitsfunktion wie beispielsweise der STO-Funktion, Insbesondere bei Langstatorlinearmotoren (LLMs), ist im Fehlerfall eine sichere Unterbrechung von Stromkreisen notwendig, weshalb es wichtig ist, die Funktion von Schaltern zur Unterbrechung dieser Stromkreise sicherzustellen. "Sicher" ist in diesem Zusammenhang immer im Sinne einer funktionalen Sicherheit zu verstehen, mit der sichergestellt werden soll, dass eine bestimmte Funktion mit ausreichender Zuverlässigkeit, je nach der geforderten Sicherheitsanforderung (z.B. eine Sicherheitsanforderungsstufe oder SIL), gewährleistet werden kann. Ist der betreffende Schalter beispielsweise längere Zeit geschlossen, da lange Zeit kein Fehlerfall eintritt, so kann es vorkommen, dass sich bei Eintreten eines Fehlerfalls der Schalter nicht öffnen lässt. Dieser Effekt kann z.B. aufgrund von Korrosion oder durch ein Festschweißen aufgrund dauerhaft geführter Ströme auftreten. Somit wäre es notwendig, die korrekte Funktion des Schalters regelmäßig zu testen. Natürlich würde bei einem derartigen Test des Schalters der eigentliche Stromkreis unterbrochen werden, weshalb das Testen im Betrieb nicht ganz trivial ist.

Die DE 103 07 999 A1 offenbart eine Antriebssteuerung eines Stromrichters, wobei eine Prüfung von Schaltern auch im laufenden Betrieb und ohne Betriebsunterbrechung möglich ist. Dabei sind zwischen zwei Punkten ein erster Zweig und ein dazu serieller zweiter Zweig zum Schalten eines Signals vorgesehen, wobei im ersten Zweig ein erster Schalter und ein zweiter Schalter seriell geschaltet sind und im zweiten Zweig ein dritter Schalter und ein vierter Schalter seriell geschaltet sind.

Es ist Aufgabe der gegenständlichen Erfindung, eine Schaltvorrichtung und ein Verfahren zum sicheren Schalten eines Signals anzugeben.

Diese Aufgabe wird erfindungsgemäß durch ein Verfahren gelöst, indem das Signal in einem ersten den ersten Punkt und zweiten Punkt verbindenden Zweig über einen ersten Schalter und einen seriellen zweiten Schalter geführt wird und das Signal in einem zum ersten Zweig parallelen und den ersten Punkt und zweiten Punkt verbindenden zweiten Zweig über einen dritten Schalter und einen seriellen vierten Schalter geführt wird. In einer Testsequenz wird der erste Schalter für eine erste Zeitspanne geöffnet und wieder geschlossen, der zweite Schalter für eine zweite Zeitspanne geöffnet und wieder geschlossen, der dritte Schalter, für eine dritte Zeitspanne geöffnet und wieder geschlossen, und der vierte Schalter für eine vierte Zeitspanne geöffnet und wieder geschlossen, wobei weder die erste, noch die zweite Zeitspanne mit der dritten oder vierten Zeitspanne überlappen. Die Funktion der Schalter während der jeweiligen Zeitspanne wird getestet und bei Fehlfunktion zumindest eines Schalters wird ein Fehlersignal generiert.

Weiters wird diese Aufgabe durch eine Schaltvorrichtung gelöst, bei der zwischen dem ersten Punkt und dem zweiten Punkt ein erster Zweig mit einem ersten Schalter und einem seriellen zweiten Schalter, und parallel zum ersten Zweig ein zweiter Zweig mit einem dritten Schalter und einem seriellen vierten Schalter angeordnet ist. Es ist zumindest eine Steuereinheit vorgesehen, die mit den Schaltern verbunden ist und ausgestaltet ist diese mittels Steuersignalen anzusteuern. Weiters ist eine Testeinrichtung vorgesehen, die mit der zumindest einen Steuereinheit verbunden ist und ausgestaltet ist, die zumindest eine Steuereinheit anzuweisen, in einer Testsequenz den ersten Schalter für eine erste Zeitspanne zu öffnen und zu wieder zu schließen, den zweiten Schalter für eine zweite Zeitspanne zu öffnen und wieder zu schließen, den dritten Schalter für eine dritte Zeitspanne zu öffnen und wieder zu schließen, und den vierten Schalter für eine vierte Zeitspanne zu öffnen und wieder zu schließen, wobei weder die erste, noch die zweite Zeitspanne mit der dritten oder vierten Zeitspanne überlappen. Zudem ist zumindest eine Prüfeinheit vorgesehen und ausgestaltet die Funktion der Schalter während der jeweiligen Zeitspanne zu prüfen und bei einer Fehlfunktion zumindest eines Schalters ein Fehlersignal zu generieren.

Zumindest zwei parallele Zweige verbinden somit den ersten Punkt und den zweiten Punkt und übertragen jeweils das Signal. Jeder Zweig weist zumindest zwei Schalter auf, wobei selbstverständlich auch mehr als zwei Zweige und in den jeweiligen Zweigen auch mehr als zwei Schalter vorgesehen sein können, um eine zusätzliche Redundanz zu erzeugen. In einer Testsequenz werden alle Schalter zumindest einmal geöffnet und die Funktion der Schalter getestet. Die Schalter können dabei grundlegend als Öffner oder auch als Schließer ausgeführt sein. Durch die parallele Führung des Signals über die zumindest zwei Zweige können somit die Schalter eines Zweiges geöffnet und wieder geschlossen werden. Damit wird das Signal zwar in diesem Zweig unterbrochen, jedoch über einen anderen Zweig zwischen dem ersten Punkt und dem zweiten Punkt weitergeführt - sofern die Schalter des anderen Zweigs zu diesem Zeitpunkt geschlossen bleiben. Die Schalter, die geöffnet und wieder geschlossen werden, werden während des Schaltvorgangs, d.h. während des Öffnens, und/oder während des geöffneten Zustands und/oder während des Schließens durch die Prüfeinrichtung auf Funktion geprüft, wobei bei Fehlfunktion zumindest eines Schalters ein Fehlersignal generiert wird, welches ausgegeben und/oder weiter verarbeitet werden kann. Selbstverständlich können auch mehrere voneinander getrennte Steuereinheiten zum Ansteuern von mehreren Schaltern vorgesehen sein oder auch je eine separate Steuereinheit pro Schalter. Damit ist eine weitere Ausfallsicherheit gewährleistet.

Vorteilhafterweise ist die zumindest eine Prüfeinheit mit der zumindest einen Steuereinheit verbunden und ausgestaltet, bei Generierung eines Fehlersignals die zumindest eine Steuereinheit anzuweisen, die Schalter zum Öffnen anzusteuern. Bei Verwendung mehrerer redundanter Prüfeinheiten, die jeweils ein Fehlersignal generieren, ist ebenso eine größere Ausfallsicherheit gegeben. "Ansteuern" bedeutet hierbei nicht zwingend, dass dies aktiv passieren muss. Die Schalter können auch als Schließer ausgeführt sein, die ohne Ansteuerung z.B. durch Steuersignale standardmäßig geöffnet sind. Es kann natürlich auch passieren, dass ein Steuersignal unterbrochen ist, womit keine direkte Ansteuerung zum Öffnen erfolgen kann. In diesem Fall ist es insbesondere von Vorteil, wenn die Schalter standardmäßig, d.h. auch ohne Anliegen eines Steuersignals, geöffnet sind. Somit wird das von der zumindest einen Prüfeinheit generierte Fehlersignal verarbeitet und an die zumindest eine Steuereinheit weitergeleitet, welche das Signal auf allen Zweigen unterbricht. Dies ist möglich, sofern weiterhin zumindest ein Schalter pro Zweig funktionsfähig ist, d.h. geöffnet werden kann. Je mehr Schalter in einem Zweig vorhanden sind, desto größer ist die Wahrscheinlichkeit bei einer Fehlfunktion das Signal mittels der verbliebenden Schalter in diesem Zweig unterbrechen zu können.

Vorteilhafterweise wird ein erstes Potential eines zwischen dem ersten und zweiten Schalter befindlichen ersten Testpunkts geprüft und ein zweites Potential eines zwischen dem dritten und vierten Schalter befindlichen zweiten Testpunkts geprüft, um auf eine Fehlfunktion zumindest eines Schalters zu schließen, wobei es besonders vorteilhaft ist, wenn das erste Potential während der ersten Zeitspanne und/oder der zweiten Zeitspanne geprüft wird und das zweite Potential während der dritten Zeitspanne und/oder der vierten Zeitspanne geprüft wird. Es kann somit auf eine Fehlfunktion zumindest eines Schalters geschlossen werden, wenn der erste Testpunkt und/oder der zweite Testpunkt nicht das Potential aufweisen, welches bei korrekt geöffneten bzw. geschlossenen verbundenen Schaltern anliegen sollte. Die Zeitspannen können der zumindest einen Prüfeinheit von der Testeinrichtung oder auch von der zumindest einen Steuereinheit übermittelt werden. Besonders vorteilhaft ist es jedoch, wenn die Testeinrichtung anhand der Potentiale erkennt, ob die Schalter geschlossen oder offen sind und daraus auf die ordnungsgemäße Funktion der Schalter schließt.

Vorteilhafterweise überlappen jeweils die erste und zweite Zeitspanne und die dritte bzw. vierte Zeitspanne zumindest teilweise. Damit können das erste Potential während dem Überlappen der ersten und zweiten Zeitspanne und das zweite Potential während dem Überlappen der dritten und vierten Zeitspanne geprüft werden, was eine paarweise Prüfung der Schalter eines Zweiges ermöglicht.

Es kann während dem Überlappen der ersten und zweiten Zeitspanne das erste Potential mit dem zweiten Potential verglichen werden und während dem Überlappen der dritten und vierten Zeitspanne das zweite Potential mit dem ersten Potential verglichen werden. Es kann beispielsweise ein Schalter eines Zweiges geöffnet und damit potentialfrei sein. Damit kann davon ausgegangen werden, dass die Schalter des anderen Zweiges geschlossen sind und damit auf dem Potential des ersten Punkts bzw. des zweiten Punkts (üblicherweise weisen der erste Punkt und der zweite Punkt dasselbe Potential auf, da sie über zumindest einen Zweig verbunden sind) liegen müssen. Ist dem nicht der Fall, so muss einer der Schalter eine Fehlfunktion aufweisen.

Ganz besonders vorteilhaft ist es, wenn der erste Testpunkt während dem Überlappen der ersten und zweiten Zeitspanne auf Potentialfreiheit geprüft wird und der zweite Testpunkt während dem Überlappen der dritten und vierten Zeitspanne auf Potentialfreiheit geprüft wird. Sind beispielsweise beide mit dem jeweiligen Testpunkt verbundenen Schalter korrekt geöffnet, so müsste dieser Testpunkt zum Zeitpunkt der Überlappung der Zeitspannen der mit dem Testpunkt verbundenen Schalter ein sogenanntes "floating potential" haben, d.h. potentialfrei sein. Ist jedoch ein Schalter defekt, d.h. nicht korrekt geöffnet, so liegt das Potential des ersten Punkts bzw. des zweiten Punkts (je nachdem welchen Punkt der Schalter mit dem jeweiligen Testpunkt verbindet) auch am Testpunkt an.

Es kann auch zumindest ein Sperreingang vorgesehen sein, der ausgestaltet ist, bei Anliegen eines Sperrsignals die Schalter zum Öffnen anzusteuern. Das Sperrsignal kann extern angelegt werden, womit beispielsweise eine STO-Funktion realisiert werden kann, um das Signal sicher zu unterbrechen. Damit stellt der Sperreingang einen STO-Eingang und das Sperrsignal ein STO-Signal dar.

Vorteilhafterweise ist der zumindest eine Sperreingang mit der zumindest einen Steuereinheit verbunden und ausgestaltet diese bei Anliegen eines Sperrsignals anzuweisen die Schalter zum Öffnen anzusteuern. Der zumindest eine Sperreingang könnte natürlich auch ausgestaltet sein, die Schalter bei Empfang eines Sperrsignals selbsttätig über spezielle Abschaltsignale zum Öffnen anzusteuern. Natürlich kann der zumindest eine Sperreingang auch die Schalter sowohl über Abschaltsignale zum Öffnen ansteuern und auch zusätzlich die zumindest eine Steuereinheit anweisen die Schalter mittels der Steuersignale zu öffnen. Damit wird durch erhöhten Schaltungsaufwand eine weitere Redundanz erzeugt, da die Schalter über die Abschaltsignale, sowie über die Steuersignale zum Öffnen angesteuert werden.

Vorteilhafterweise wird das Sperrsignal dynamisiert und anschließend gleichgerichtet, bevor es weiter in der Schaltvorrichtung verarbeitet wird um die Schalter zum Öffnen anzusteuern. Dazu kann der zumindest eine Sperreingang über eine Gleichrichterschaltung mit der zumindest einen Steuereinheit verbunden sein, wobei die Gleichrichterschaltung ausgestaltet ist das Sperrsignal zu dynamisieren und gleichzurichten. Der Sperreingang ist also mit dem Eingang der Gleichrichterschaltung verbunden, welche ausgangsseitig mit der zumindest einen Steuereinheit verbunden ist. Der Sperreingang weist also bei Anliegen eines Sperrsignals die zumindest eine Steuereinheit dazu an die Schalter zum Öffnen anzusteuern, wobei das Signal jedoch vorher dynamisiert, d.h.in ein oszillierendes Signal gewandelt wird und anschließend gleichgerichtet wird. Damit kann einerseits das Sperrsignal verstärkt werden, da der Sperreingang üblicherweise digital konzipiert ist, und weiters ein statischer Fehlerfall ausgeschlossen werden kann. Die Gleichrichtung kann beispielsweise über eine Ladungspumpe erfolgen, um hochfrequente Störungen zu glätten und damit ein versehentliches Aktivieren des Sperrsignals zu vermeiden. In der Regel werden bei Vorliegen eines Sperrsignals die Schalter erst nach Unterschreiten einer Ansprechschwelle zum Öffnen angesteuert. Das dynamisierte und gleichgerichtete Sperrsignal verläuft somit aufgrund der Entladung des Kondensators der Ladungspumpe entsprechend einer RC-Entladekurve. Durch die Gleichrichtung wird je nach Dimensionierung des Gleichrichters ein kurzer Impuls des ursprünglichen Sperrsignals gedämpft, bzw. unterdrückt, womit die Schalter der Schalteinrichtung nicht geöffnet werden, da die Ansprechschwelle nicht erreicht wurde. So kann beispielsweise ein versehentliches Öffnen der Schalter verhindert werden. Die Dynamisierung und anschließende Gleichrichtung ermöglicht aber auch eine "sichere" Verstärkung des Sperrsignals. Durch diese Dynamisierung und anschließende Gleichrichtung wird jedoch auch ein beabsichtigtes Auslösen, durch ein dauerhaftes Anliegen des Sperrsignals um eine Auslösezeit bis zum Erreichen der Ansprechschwelle verzögert. Zudem ist die Verzögerung um die Auslösezeit hilfreich, um ein korrektes Anliegen des Sperrsignals am Sperreingang während des Betriebs zu testen. Es ist möglich, dass das Fehlersignal generiert wurde, aber nicht am Sperreingang anliegt, z.B. aufgrund eines Kabelbruchs. Es kann somit ein Sperrsignal kurz, d.h. unter der Auslösezeit ausgelöst werden, womit die Ansprechschwelle nicht erreicht wird. In dieser Zeit kann am Sperreingang überprüft werden, ob das Sperrsignal korrekterweise anliegt, bevor das Signal tatsächlich unterbrochen wird. Ein testweise (sehr) kurz angelegtes Sperrsignal kann somit z.B. mittels der Ladungspumpe direkt in der Schaltvorrichtung gefiltert werden. Es ist aber auch möglich, dass aufgrund eines testweise angelegten Sperrsignals das Signal kurz unterbrochen wird, z.B. da die Unterbrechung etwas länger als die Auslösezeit ist. Eine derartige kurzzeitige Unterbrechung des Signals kann jedoch wiederum in weiterer Folge, beispielsweise durch Stützkondensatoren am Eingang einer durch das Signal angesteuerten Treiberschaltung einer Brückenschaltung, ausgefiltert werden. Damit wird also das Signal selbst gestützt, womit eine kurze Unterbrechung des Sperrsignals sich in weiterer Folge nicht negativ auf die Funktion der Schaltung auswirkt und das Signal aufrechterhalten wird.

Es kann das Sperrsignal auch an mehreren Sperreingängen anliegen, beispielsweise wenn mehrere Steuereinheiten und/oder Gleichrichterschaltungen vorhanden sind. So können beispielsweise zwei Gleichrichterschaltungen jeweils das Sperrsignal empfangen und weiters jeweils zumindest einen Schalter pro Zweig zum Öffnen anweisen, z.B. über den Schalter zugewiesene Steuereinheiten. So kann ein erster Sperreingang bei Anliegen des Sperrsignals z.B. über eine erste Gleichrichterschaltung den ersten Schalter im ersten Zweig und den dritten Schalter im zweiten Zweig (ggf. jeweils über eine eigene Steuereinheit pro Schalter) zum Öffnen ansteuern. Und ein zweiter Sperreingang bei Anliegen des Sperrsignals, z.B. über eine zweite Gleichrichterschaltung und eine den zweiten Schalter im ersten Zweig und den vierten Schalter im zweiten Zweig (ggf. jeweils ebenso über eine eigene Steuereinheit pro Schalter) zum Öffnen ansteuern.

Es kann auch ein weiterer Serienschalter vorhanden sein, der zwischen den ersten und den zweiten Punkt in Serie zu den beiden Zweigen geschaltet ist und ebenso von der zumindest einen Prüfeinheit und/oder durch das Sperrsignal zum Öffnen angesteuert werden kann.

Eine erfindungsgemäße Schaltvorrichtung kann zum Abschalten der Versorgungsspannung der Treiberschaltung einer Brückenschaltung und/oder eines der Treiberschaltung zugeführten PWM-Signals eines Langstatorlinearmotors oder eines rotativen Motors verwendet werden. Damit stellt das Signal die Versorgungsspannung der Treiberschaltung der Leistungsschalter und/oder das PWM-Signal der Treiberschaltung dar. So kann eine STO-Funktion realisiert werden, indem das Signal bei Anliegen eines Fehlersignals unterbrochen wird.

Die gegenständliche Erfindung wird nachfolgend unter Bezugnahme auf die Figuren 1 bis 7 näher erläutert, die beispielhaft, schematisch und nicht einschränkend vorteilhafte Ausgestaltungen der Erfindung zeigen. Dabei zeigt
Fig.1 eine Ausgestaltung der Schaltvorrichtung,
Fig.2 eine Testsequenz mit sequentiellen Zeitspannen,
Fig.3 eine Testsequenz mit paarweise überlagerten Zeitspannen,
Fig.4 eine Schaltvorrichtung mit einer Sperreinrichtung und einer Testeinrichtung zur Potentialprüfung der Testpunkte,
Fig.5 die Verwendung einer Schaltvorrichtung zur Realisierung einer STO-Funktion Signals eines Langstatorlinearmotors,
Fig.6 eine Gleichrichterschaltung zum dynamisieren und Gleichrichten des Sperrsignals,
Fig.7 eine besonders redundante Realisierung einer Schaltvorrichtung.

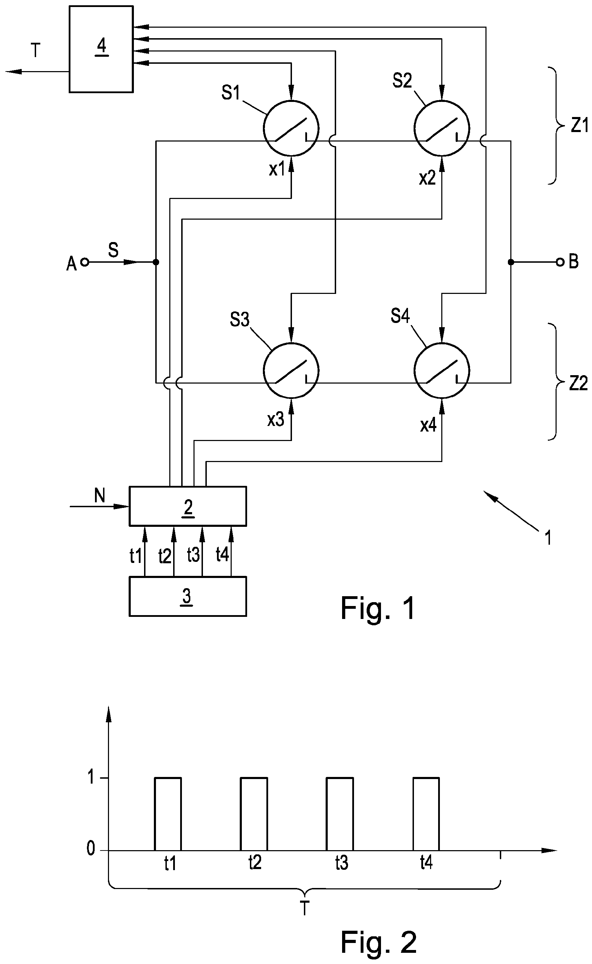

Fig. 1 zeigt eine erfindungsgemäße Schaltvorrichtung 1 zum Abschalten eines Signals S, welches hier von einem ersten Punkt A zu einem zweiten Punkt B übertragen wird. Der erste Punkt A ist über einen ersten Zweig Z1 und einen dazu parallelen zweiten Zweig Z2 mit dem zweiten Punkt B verbunden. Damit kann das Signal S sowohl über den ersten Zweig Z1, als auch über den zweiten Zweig Z2 vom ersten Punkt A zum zweiten Punkt B, bzw. bei umgekehrter Richtung des Signals S auch vom zweiten Punkt B zum ersten Punkt A, übertragen werden. Im ersten Zweig Z1 sind ein erster Schalter S1 und ein serieller zweiter Schalter S2 angeordnet, im zweiten Zweig Z2 in analoger Weise ein dritter Schalter S3 und ein serieller vierter Schalter S4. Die Schalter S1, S2, S3, S4 sind oftmals nullaktiv ausgeführt, was bedeutet, dass sie geschlossen sind, wenn sie aktiviert und geöffnet sind, wenn sie nicht aktiviert sind, und werden vorteilhafterweise als Halbleiterschalter, z.B. als Bipolar-Transistoren, realisiert. Selbstverständlich können in der Schaltvorrichtung 1 auch mehr Schalter S1, S2, S3, S4 und mehr parallele Zweige Z1, Z2, als in Fig. 1 dargestellt, vorhanden sein, um eine zusätzliche Redundanz zu erzeugen.

Das Signal S ist ein elektrisches Signal, üblicherweise eine elektrische Spannung, beispielsweise eine Versorgungsspannung für ein oder mehrere Bauteile oder eine Impulsfolge (z.B. als PWM-Signal).

Es ist eine Steuereinheit 2 vorgesehen, welche die Schalter S1, S2, S3, S4 unter Verwendung geeigneter Steuersignale x1, x2, x3, x4 öffnen, und schließen kann. Bei geschlossenen Schaltern S1, S2, S3, S4 kann das Signal S über den ersten Zweig Z1 und auch über den zweiten Zweig Z2 vom ersten Punkt A zum zweiten Punkt B, bzw. umgekehrt vom zweiten Punkt B zum ersten Punkt A fließen. Sind der erste und/oder zweite Schalter S1, S2 im ersten Zweig Z1 geöffnet, so kann das Signal S weiterhin über die geschlossenen, dritten und vierten Schalter S3, S4 des zweiten Zweiges Z2 fließen. Im umgekehrten Fall könnte bei geöffneten dritten und/oder vierten Schaltern S3, S4 das Signal S über die geschlossenen ersten und zweiten Schalter S1, S2 fließen. Ist zumindest je ein Schalter S1, S2, S3, S4 beider Zweige Z1, Z2 geöffnet, so wäre das Signal S unterbrochen. Dies wäre in Fig. 1 der Fall, wenn der erste Schalter S1 und/oder der zweite Schalter S2 geöffnet sind (Signal S über den ersten Zweig Z1 unterbrochen) und der dritte Schalter S3 und/oder der vierte Schalter S4 geöffnet sind (Signal S über den zweiten Zweig unterbrochen).

Weist jedoch ein Schalter des ersten Zweiges Z1, d.h. hier der erste oder zweite Schalter S1, S2, eine Fehlfunktion auf und kann damit nicht geöffnet werden, so kann das Signal S dennoch über den/die verbleibenden funktionsfähigen Schalter S1, S2 im ersten Zweig Z1 unterbrochen werden. Selbiges gilt für die Schalter im zweiten Zweig Z2, d.h. hier den dritten und vierten Schalter S3, S4. Somit kann bei einer Fehlfunktion eines Schalters S1, S2, S3, S4 in einem Zweig Z1, Z2 das Signal S dennoch sicher in diesem Zweig Z1, Z2 abgeschaltet werden. Je mehr Schalter S1, S2, S3, S4 in einem Zweig Z1, Z2 vorhanden sind, desto größer ist natürlich die Wahrscheinlichkeit, bei einer Fehlfunktion das Signal S mittels der verbliebenden Schalter S1, S2, S3, S4 unterbrechen zu können. Durch diese Redundanz soll die funktionale Sicherheit (z.B. im Sinne der Norm EN/IEC 61508) der Schaltvorrichtung 1 gewährleistet werden.

Zu beachten ist jedoch, dass bei mehreren Zweigen Z1, Z2 mehrere parallele Pfade für das Signal S existieren, die alle durch Schalter S1, S2, S3, S4 getrennt werden müssen. Natürlich ist es nicht möglich, das Signal S zwischen dem ersten Punkt A und dem zweiten Punkt B zu unterbrechen, wenn alle Schalter S1, S2, S3, S4 eines selben Zweiges Z1, Z2, d.h. hier beispielsweise der erste Schalter S1 und der zweite Schalter S2 des ersten Zweiges Z1 oder der dritte Schalter S3 und der vierte Schalter S4 des zweiten Zweiges Z2, eine Fehlfunktion aufweisen, d.h. sich nicht öffnen lassen.

Um das Risiko der Fehlfunktion eines Schalters S1, S2, S3, S4 zu minimieren, und damit die funktionale Sicherheit weiter zu erhöhen, ist auf einer Testeinrichtung 3 eine Testsequenz T vorgesehen, die mittels der Steuersignale x1, x2, x3, x4 der Steuereinheit 2 die Schalter S1, S2, S3, S4 im laufenden Betrieb, d.h. während das Signal S zwischen dem ersten Punkt A und dem zweiten Punkt B geführt wird, öffnet und schließt, während eine Prüfeinheit 4 die korrekte Funktionsweise der Schalter S1, S2, S3, S4 prüft. In der Testsequenz T werden der erste Schalter S1 für eine erste Zeitspanne t1 geöffnet und danach wieder geschlossen, der zweite Schalter S2 für eine zweite Zeitspanne t2 geöffnet und danach wieder geschlossen, der dritte Schalter S3 für eine dritte Zeitspanne t3 geöffnet und danach wieder geschlossen, und der vierte Schalter S4 für eine vierte Zeitspanne t4 geöffnet und danach wieder geschlossen, wie in Fig.2 beispielhaft dargestellt. Die Reihenfolge der Zeitspannen t1, t2, t3, t4 ist dabei grundlegend nicht von Bedeutung, es können einzelne oder mehrere Schalter S1, S2, S3, S4 auch mehrmals in einer Testsequenz T geschaltet werden. Die Funktion der Schalter S1, S2, S3, S4 wird von der Prüfeinheit 4 während der Zeitspannen t1, t2, t3, t4, d.h. während des Öffnen, des Schließens, oder während dem geöffneten Zustand der Schalter S1, S2, S3, S4 getestet. Wird die Fehlfunktion zumindest eines Schalters S1, S2, S3, S4 von der Prüfeinheit 4 festgestellt, so wird ein Fehlersignal F ausgegeben und/oder auch anderweitig genutzt, beispielsweise um ein STO-Signal zu erzeugen und damit die Schalter S1, S2, S3, S4 zum Öffnen anzusteuern, wie weiter unten beschrieben.

In Fig. 2 ist eine Testsequenz T mit aufeinanderfolgenden, nicht überlappenden Zeitspannen t1, t2, t3, t4 dargestellt. Damit ist auf jeden Fall sichergestellt, dass während des Funktionstests das Signal S zwischen dem ersten Punkt A und dem zweiten Punkt B nicht unterbrochen ist. Prinzipiell ist eine beliebige Anordnung der Zeitspannen t1, t2, t3, t4 möglich, sofern eine Überlappung der Zeitspannen t1, t2, t3, t4 unterschiedlicher Zweige vermieden wird. In letzterem Fall wäre das Signal S, sowohl über den ersten Zweig Z1, als auch über den zweiten Zweig Z2 und damit gesamtheitlich unterbrochen.

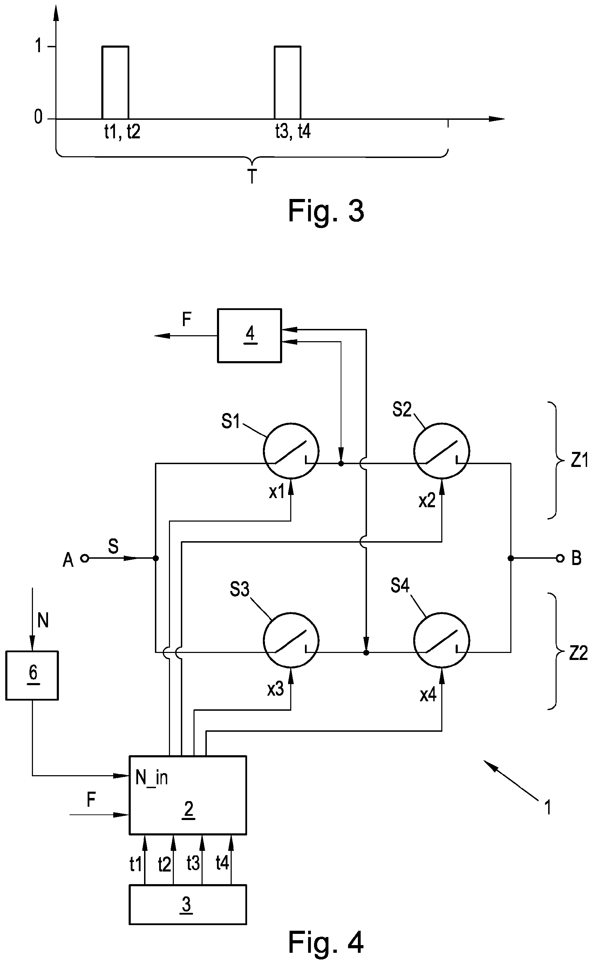

Um auf eine Fehlfunktion zumindest eines Schalters S1, S2, S3, S4 zu schließen, kann die Prüfeinheit 4 ein erstes Potential (z.B. während der ersten Zeitspanne t1 und der zweiten Zeitspanne t2) eines zwischen dem ersten und zweiten Schalter S1,S2 befindlichen ersten Testpunkts P1 prüfen, sowie ein zweites Potential (z.B. während der dritten Zeitspanne t3 und/oder der vierten Zeitspanne t4) eines zwischen dem dritten und vierten Schalter S3, S4 befindlichen zweiten Testpunkts P2 prüfen. Fig. 3 zeigt eine weitere vorteilhafte Testsequenz T, bei der jeweils die erste und zweite Zeitspanne t1, t2 und die dritte bzw. vierte Zeitspanne t3, t4, hier vollständig, überlappen. Die Schalter S1, S2 und S3, S4 jeweils eines Zweiges Z1, Z2 werden folglich in der Testsequenz T gleichzeitig geschaltet. Vorteilhafterweise wird z.B. während dem Überlappen der ersten und zweiten Zeitspanne t1, t2 von der Prüfeinheit 4 das Potential eines zwischen dem ersten und zweiten Schalter S1, S2 befindlichen ersten Testpunkt P1 geprüft. Zudem wird während dem Überlappen der dritten und vierten Zeitspanne t3, t4 von der Prüfeinheit 4 das Potential eines zwischen dem dritten und vierten Schalter S1, S2 befindlichen zweiten Testpunkts P2 geprüft. Eine derartige Ausgestaltung ist in Fig. 4 dargestellt. Es könnte nun während dem Überlappen der ersten und zweiten Zeitspanne t1, t2 das erste Potential mit dem zweiten Potential verglichen werden und während dem Überlappen der dritten und vierten Zeitspanne t3, t4 das zweite Potential mit dem ersten Potential verglichen werden. Besonders vorteilhaft ist es jedoch, wenn der erste Testpunkt P1 während dem Überlappen der ersten und zweiten Zeitspanne t1, t2 auf Potentialfreiheit geprüft wird und der zweite Testpunkt P2 während dem Überlappen der dritten und vierten Zeitspanne t3, t4 auf Potentialfreiheit geprüft wird. So wird von der Prüfeinheit 4 auf eine Fehlfunktion zumindest des ersten und/oder zweiten Schalters S1, S2 geschlossen, wenn während der ersten bzw. überlappenden zweiten Zeitspanne t1, t2 der erste Testpunkt P1 nicht potentialfrei, d.h. hochimpedant, ist. Gleichermaßen wird von der Prüfeinheit 4 auf eine Fehlfunktion zumindest des dritten und/oder vierten Schalters S3, S4 geschlossen, wenn während der dritten bzw. überlappenden vierten Zeitspanne t3, t4 der zweite Testpunkt P2 nicht potentialfrei ist. Ist ein Schalter S1, S2, S3, S4 defekt, so kann entweder das Potential des Punktes A bzw. des Punktes B am jeweiligen Testpunkt P1, P2 anliegen, was ein Indiz für einen fehlerhaften Schalter S1, S2, S3, S4 ist. Für diese Ausgestaltung ist es vorteilhaft, wenn die Schalter S1, S2, S3, S4 als Halbleiterschalter, wie z.B. Bipolartransistoren, ausgeführt sind, da somit ein Sperren in beide Richtungen gewährleistet wird. Sind die zwei Schalter S1, S2, S3, S4 eines Zweiges Z1, Z2 gleichzeitig geöffnet, so müsste der jeweilige erste bzw. zweite Testpunkt P1, P2 potentialfrei sein, was durch die Prüfeinrichtung 4 in einfacher Weise überprüft werden kann, beispielsweise durch Aufschalten einer Last auf den jeweiligen Testpunkt P1, P2 und eine Überprüfung auf einen fließenden Laststrom. Es könnte auch während dem Überlappen der ersten und zweiten Zeitspanne t1, t2 das erste Potential mit dem zweiten Potential verglichen werden und während dem Überlappen der dritten und vierten Zeitspanne t3, t4 das zweite Potential mit dem ersten Potential verglichen und daraus auf eine Fehlfunktion der Schalter S1, S2, S3, S4 geschlossen werden.

In Fig. 4 ist in der Schaltvorrichtung 1 zudem ein Sperreingang N_in vorhanden. Der Sperreingang N_in kann ein Sperrsignal N, beispielsweise von einer übergeordneten Steuerung, von einem Not-Aus Taster, oder auch das Fehlersignal F als Sperrsignal N empfangen. Dadurch wird ein Öffnen der Schalter S1, S2, S3, S4, veranlasst um das Signal S auf beiden Zweigen Z1, Z2 zu unterbrechen. Vorteilhafterweise ist der Sperreingang N_in mit der Steuereinheit 2 verbunden oder, wie in Fig. 4 dargestellt, integraler Bestandteil einer Gleichrichterschaltung 6, die das Sperrsignal N dynamisiert und gleichrichtet. Der Sperreingang N_in kann beispielsweise, z.B. wenn keine Gleichrichterschaltung 6 vorhanden ist integraler Bestandteil der Steuereinheit 2 sein. Ein am Sperreingang N_in anliegendes Sperrsignal N veranlasst somit das Öffnen der Schalter S1, S2, S3, S4 über die Steuereinheit 2 und damit über die Steuersignale x1, x2, x3, x4. Es ist natürlich auch vorstellbar, dass der Sperreingang N_in die Schalter S1, S2, S3, S4 über eigene Signalpfade in Form von Abschaltsignalen öffnet. Auch ist eine redundante Ausgestaltung, bei der sowohl die Steuersignale x1, x2, x3, x4 über die Steuereinheit 2, als auch extra Abschaltsignale genutzt werden um das Öffnen der Schalter S1, S2, S3, S4 zu veranlassen vorstellbar. Es ist aber auch ein Ansteuern nur über die Steuersignale x1, x2, x3, x4 der Steuereinheit 2 oder spezielle Abschaltsignale möglich.

Bei Vorliegen eines Sperrsignals N bliebe für den erfolgreichen Abschaltvorgang des Signals S, d.h. dem Veranlassen des Öffnen der Schalter S1, S2, S3, S4 durch ein zugehöriges Steuersignal x1, x2, x3, x4 und/oder ein zugehöriges Abschaltsignale somit lediglich ein Risiko einer Fehlfunktion eines Schalter S1, S2, S3, S4 seit dem letzten erfolgreichen Funktionstest. Vorteilhafterweise werden daher die Testsequenz T von der Testeinrichtung 3 und der Funktionstest der Schalter S1, S2, S3, S4 durch die Prüfeinheit 4 laufend, vorzugsweise in definierten, regelmäßigen Abständen, wiederholt, womit das Risiko einer Fehlfunktion eines Schalters S1, S2, S3, S4 minimiert wird, da laufend Funktionstests durchgeführt werden. Doch selbst bei Fehlfunktion eines Schalters S1, S2, S3, S4 nach einem erfolgreichen Funktionstest kann das Signal S wie oben beschrieben über den verbleibenden funktionierenden Schalter S1, S2, S3, S4 im selben Zweig Z1, Z2 abgeschaltet werden, wenn ein Sperrsignal N vorliegt. Dass gar zwei Schalter S1, S2, S3, S4 nach dem jeweiligen erfolgreichen Funktionstest defekt wurden und daher bei Vorliegen eines Sperrsignals N eine Fehlfunktion aufweisen, ist nahezu auszuschließen. Selbst bei gleichzeitiger Fehlfunktion je eines Schalters S1, S2, S3, S4 eines Zweigs Z1, Z2 kann das Signal S über die jeweils verbleibenden funktionsfähigen Schalter S1, S2, S3, S4 beider Zweige Z1, Z2 abgeschaltet werden. Lediglich bei Fehlfunktion zweier Schalter S1, S2, S3, S4 desselben Zweiges Z1, Z2, wobei die Fehlfunktion das Öffnen verhindert, könnte das Signal S nicht abgeschaltet werden. Der Funktionstest erhöht damit maßgeblich die funktionale Sicherheit der Schalteinrichtung 1.

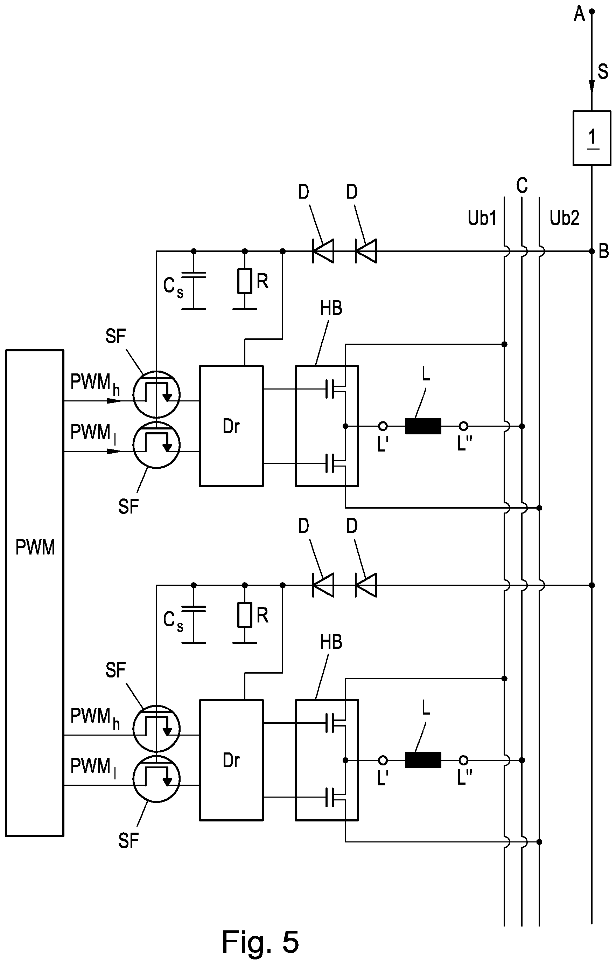

Fig. 5 zeigt die vorteilhafte Verwendung des erfindungsgemäßen Verfahrens zur Realisierung einer STO-Funktion eines Langstatorlinearmotors 5, wobei ein Signal S durch die Schaltvorrichtung 1 unterbrochen wird. Ein Stator eines Langstatorlinearmotors (LLM) besteht aus einer Vielzahl von nebeneinander angeordneten LLM-Spulen L, die zusammen den Stator des LLM bilden. Diese LLM-Spulen L werden einzeln oder in Gruppen angesteuert. Durch das Ansteuern der LLM-Spulen L wird ein bewegtes Magnetfeld erzeugt, das mit Erregungsmagneten (in der Regel Permanentmagnete) an einer Transporteinheit des LLM zusammenwirkt, um die Transporteinheit entlang des Stators zu bewegen. Der grundsätzliche Aufbau und die Funktion eines LLM ist dabei hinlänglich bekannt, weshalb hier nicht näher darauf eingegangen wird. Ebenso werden aus Gründen der Übersichtlichkeit lediglich zwei LLM-Spulen L dargestellt und auf eine Darstellung der Transporteinheiten, Erregungsmagnete, usw. verzichtet. Zum Bestromen der LLM-Spulen L, d.h. zur Erzeugung des Magnetfeldes, wird eine Betriebsspannung zwischen einem ersten Betriebspotential Ub1 und einem zweiten Betriebspotential Ub2 zur Verfügung gestellt. Werden Halbbrücken HB, jeweils bestehend aus einem Leistungsschalterpaar, für die Ansteuerung der LLM-Spulen L verwendet, so wird jede LLM-Spule L über einen ersten Spulenanschluss L' mit einem zwischen den Leistungsschaltern eines Leistungsschalterpaars befindlichen Mittelpunkt verbunden. Die jeweiligen zweiten Anschlüsse L" der LLM-Spulen L werden zu einem Regelungspunkt C verbunden, welcher beispielsweise auf ein vorgegebenes Potential gehalten wird. Durch das Ansteuern eines Leistungsschalters wird ein Strom in die LLM-Spulen L des Langstatorlinearmotors eingeprägt. Das Signal S führt hier einerseits als Versorgungsspannung jeweils über zwei serielle Dioden D zu den Treiberschaltungen Dr, welche die Halbbrücken HB ansteuern. Die Dioden D dienen als Schutz dagegen, dass im Falle eines Defekts eines Bauteils des Langstatorlinearmotors eine Spannung in die Schaltvorrichtung eingeschleust wird.

Sind während der Testsequenz T die Schalter S1, S2 des ersten Zweiges Z1, bzw. die Schalter S1, S2 des zweiten Zweiges Z2 geöffnet, so wird von der Prüfeinrichtung 3 überprüft, ob der erste Testpunkt T1, bzw. der zweite Testpunkt 2 potentialfrei ist. Während dieser Zeit sind die Schalter S1, S2, S3, S4 des jeweils anderen Zweiges Z1, Z2 geschlossen, womit die Treiber Dr weiterhin mit dem Signal S verbunden sind und somit durch die Testsequenz T keine Einbrüche der Spannungsversorgung durch das Signal S an den Treibern Dr entstehen, womit die Stützkondensatoren C_{S} an den Eingängen der Treiber Dr relativ klein gewählt werden können. In Folge dessen lässt sich die Reaktionszeit auf eine Unterbrechung des Signals S deutlich verkürzen. Wird das Signal S unterbrochen, so werden die Treiberschaltungen Dr deaktiviert und damit die Halbbrücken HB, z.B. mittels zweier MOS-FETs ausgeführt, nicht mehr mit Spannung versorgt. Die Stützkondensatoren C_{S} sind jedoch vorteilhafterweise derart dimensioniert, dass kurze Ausfälle des Signals S, beispielsweise aufgrund eines testweise kurzzeitig generierten Fehlersignal N, überbrückt werden, womit das Signal aufrechterhalten wird. Weiters wird hier zusätzlich das von der PWM-Steuerung PWM stammende PWM-Signal PWMₕ, PWMₗ unterbrochen. Dies erfolgt über als Sourcefolger geschaltete Transistoren SF, die das PWM-Signal PWM_{h,l} bei Unterbrechung des Signals S nicht mehr an die Treiber Dr weiterleiten und über die Widerstände R auf Masse ziehen. Somit wird mittels einer durch die Schalteinheit 1 verursachte Unterbrechung des Signals S eine STO-Funktion realisiert, die vorteilhafterweise einerseits die Versorgungsspannung der Treiberschaltungen Dr der Halbbrücken HB unterbricht und andererseits das PWM-Signal PWM_{h,l} selbst unterbricht. Natürlich kann durch die STO-Funktion auch nur entweder die Versorgungspannung der Treiberschaltungen Dr oder das PWM-Signal PWMₕ,ₗ unterbrochen werden.

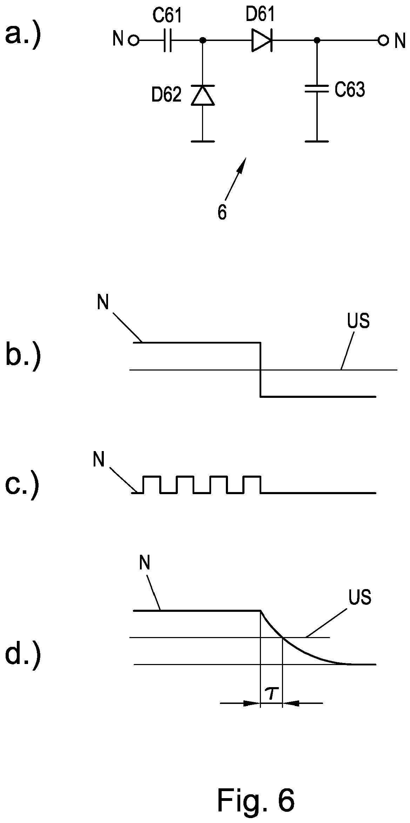

Fig. 6a zeigt eine beispielhafte Gleichrichterschaltung 6, welche das Sperrsignal N dynamisiert und gleichrichtet. Hierzu wird das nullaktive Sperrsignal N erst dynamisiert, d.h. in ein oszillierendes Signal gewandelt und in einfacher Weise mittels einer Ladungspumpe, wie in Fig. 6a durch die Gleichrichterkondensatoren C61, C63 und die Gleichrichterdioden D61, D62 gebildet, gleichgerichtet um eine Potentialtrennung zwischen dem Sperreingang N_in und der Schaltvorrichtung 1 zu realisieren. Die Gleichrichterkondensatoren C61, C63 können sich jeweils wie in sicherheitsrelevanten Anwendungen üblich natürlich auch aus zwei oder mehreren in Serie geschalteten Kondensatoren zusammensetzen, womit ein Kurzschluss eines der in Serie geschalteten Kondensatoren keinen maßgeblichen negativen Effekt hat.

Durch das anhand der Gleichrichterschaltung 6 geglättete Sperrsignal N kann beispielsweise ein versehentliches kurzes Öffnen der Schalter S1, S2, S3, S4 verhindert werden, aber auch das Sperrsignal N verstärkt werden. Ein dynamisiertes Sperrsignal N ist in Fig. 6c dargestellt, wogegen ein gleichgerichtetes dynamisiertes Sperrsignal N in Fig. 6d ersichtlich ist.

Wie in Fig. 6d angedeutet, wird jedoch durch die Gleichrichterschaltung 6 ein beabsichtigtes Öffnen der Schalter S1, S2, S3, S4 um eine Auslösezeit τ verzögert. Ohne die Gleichrichterschaltung 6, würde das Sperrsignal N, wie in Fig. 6b dargestellt, eine (z.B. durch die Steuereinheit 2 definierte) Ansprechschwelle US sofort erreichen. Das dynamisierte und gleichgerichtete Sperrsignal N erreicht die Ansprechschwelle US jedoch erst nach einer Auslösezeit τ und öffnet erst dann die Schalter S1, S2, S3, S4.

In einer Ausgestaltung mit einer Gleichrichteschaltung 6 ist es vorteilhaft, wenn das Fehlersignal F der Steuereinheit 2, wie in Fig. 4 dargestellt, nicht als Sperrsignal N über eine Gleichrichterschaltung 6, sondern direkt zugeführt wird, da das Fehlersignal F in der Regel nicht verstärkt werden muss. Zudem ist ein unbeabsichtigtes Auslösen des Fehlersignals F unwahrscheinlich und eine verlängerte Auslösezeit τ im Fehlerfall oftmals unerwünscht.

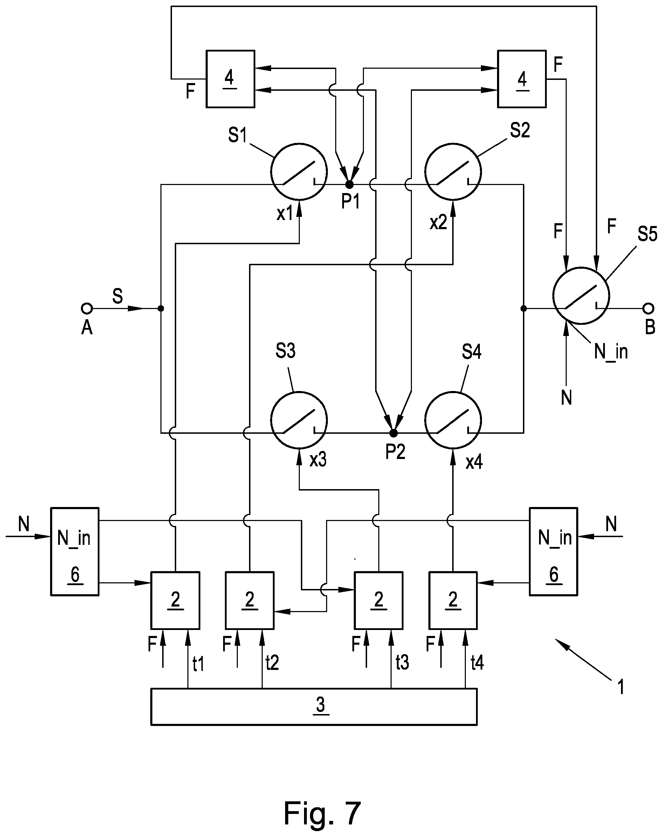

Fig. 7 zeigt eine besonders sichere Ausgestaltung, in welcher eine Testeinrichtung 3 vorhanden ist, aber jeder Schalter S1, S2, S3, S4 eine eigene mit der Testeinrichtung 3 verbundene Steuereinheit 2 aufweist, die jeweils einen Schalter S1, S2, S3, S4 mittels eines Steuersignals x1, x2, x3, x4 öffnen und schließen können. Die Testeinrichtung 3 weist, wie oben beschrieben, eine Testsequenz T auf und weist die Steuereinheiten 2 mittels der jeweiligen Zeitspannen t1, t2, t3, t4 zum Ansteuern der Schalter S1, an. Weiters sind zwei Gleichrichterschaltungen 6 vorhanden, die jeweils mit Sperreingängen N_in verbunden sind und somit jeweils das Sperrsignal N empfangen, dynamisieren und gleichrichten können. Weiters veranlasst bei Vorliegen eines Sperrsignals N jede der beiden Gleichrichterschaltungen 6 das Öffnen je eines Schalter S1, S2 des ersten Zweigs Z1 und je eines Schalter S3, S4 des zweiten Zweigs Z2. Die erste Gleichrichterschaltung 6 veranlasst so z.B. bei Anliegen eines Sperrsignals N z.B. über eine Steuereinheit 2 das Öffnen des ersten Schalters S1 im ersten Zweig Z1 und über eine Steuereinheit 2 das Öffnen des dritten Schalters im zweiten Zweig Z2. Damit wird das Signal S bereits auf beiden Zweigen Z1, Z2 unterbrochen. Zudem veranlasst in diesem Fall die zweite Gleichrichterschaltung 6 bei Anliegen eines Sperrsignals N z.B. über eine Steuereinheit 2 das Öffnen des zweiten Schalters S2 im ersten Zweig Z1 und über eine Steuereinheit 2 das Öffnen des vierten Schalters S4 im zweiten Zweig Z2. Damit wird das Signal S über die zweite Gleichrichterschaltung 6 zusätzlich unabhängig von der ersten Gleichrichterschaltung 6, d.h. dem ersten Schalter S1 und dem dritten Schalter S3 unterbrochen, womit durch diese Redundanz eine Ausfallsicherheit erzeugt wird. Das Öffnen der Schalter S1, S2, S3, S4 kann, wie in Fig. 7 dargestellt über die zugehörigen Steuereinheiten 2, und/oder auch in Form von extra Abschaltsignalen erfolgen. Die Steuereinheiten 2 weisen zudem vorteilhafterweise einen Eingang für das Sperrsignal auf um bei Anliegen eines Sperrsignals F die Schalter S1, S2, S3, S4 zum Öffnen anzusteuern.

Zudem sind in der Ausgestaltung nach Fig. 7 zwei Prüfeinrichtungen 4 vorhanden, die jeweils unabhängig voneinander ein erstes Potential des zwischen dem ersten und zweiten Schalter S1,S2 befindlichen ersten Testpunkts P1, sowie ein zweites Potential des zwischen dem dritten und vierten Schalter S3, S4 befindlichen zweiten Testpunkts P2 prüfen um auf eine Fehlfunktion zumindest eines Schalters S1, S2, S3, S4 zu schließen. Natürlich könnten die beiden Prüfeinrichtungen 4 jeweils auch auf eine andere Art die korrekte Funktion der Schalter S1, S2, S3, S4 prüfen. Wird die Fehlfunktion zumindest eines Schalters S1, S2, S3, S4 von der Prüfeinheit 4 festgestellt, so wird von den Prüfeinheiten 4 jeweils ein Fehlersignal F ausgegeben, womit die Schalter S1, S2, S3, S4 (z.B. über die jeweiligen Steuereinheiten 2) zum Öffnen angewiesen werden, und das Signal S unterbrochen wird. Weiters ist vorteilhafterweise wie in Fig. 7 abgebildet in Serie zu den Zweigen Z1, Z2 ein Serienschalter S5 angeordnet, über den das Signal S zwischen dem ersten Punkt A und dem zweiten Punkt B geführt wird und welcher ebenso durch ein anliegendes, d.h. ausgelöstes, Fehlersignal F und/oder Sperrsignal N das Signal S unterbricht, womit eine zusätzliche Redundanz zur Unterbrechung des Signals S erzeugt wird. Die Funktion des Serienschalters S5 wird nicht getestet und deckt den Spezialfall ab, dass die Testeinrichtung nicht aktiv ist, d.h. die Schalter S1, S2, S3, S4 nicht getestet werden, z.B. da dauerhaft ein Fehlersignal N anliegt. Dann lässt sich jedoch nicht detektieren, ob die Schalter S2, S4 korrekt funktionieren. Durch den Serienschalter S5 wird dennoch eine Zweifehlersicherheit der Schaltvorrichtung 1 gewahrt, d.h. dass mehr als zwei Fehler (Fehlfunktion des Schalters S2 und des Serienschalters S5 oder Fehlfunktion des Schalters S2 und des Serienschalters S5) auftreten müssten um ein Versagen der Schaltvorrichtung 1 zu bewirken, was jedoch derart unwahrscheinlich sind, dass ein Auftreten dessen vernachlässigbar ist.

## Patentansprüche

1. Verfahren zum Schalten eines Signals (S) auf einer Verbindung zwischen einem ersten Punkt (A) und einem zweiten Punkt (B), **dadurch gekennzeichnet, dass** das Signal (S) in einem ersten den ersten Punkt (A) und zweiten Punkt (B) verbindenden Zweig (Z1) über einen ersten Schalter (S1) und einen seriellen zweiten Schalter (S2) geführt wird und das Signal (S) in einem zum ersten Zweig (Z1) parallelen und den ersten Punkt (A) und zweiten Punkt (B) verbindenden zweiten Zweig (Z2) über einen dritten Schalter (S3) und einen seriellen vierten Schalter (S4) geführt wird, **dass** in einer Testsequenz (T) der erste Schalter (S1) für eine erste Zeitspanne (t1) geöffnet und wieder geschlossen wird, der zweite Schalter (S2) für eine zweite Zeitspanne (t2) geöffnet und wieder geschlossen wird, der dritte Schalter (S3), für eine dritte Zeitspanne (t3) geöffnet und wieder geschlossen wird, und der vierte Schalter (S4) für eine vierte Zeitspanne (t4) geöffnet und wieder geschlossen wird, wobei weder die erste, noch die zweite Zeitspanne (t1, t2) mit der dritten oder vierten Zeitspanne (t3, t4) überlappen, **dass** die Funktion der Schalter (S1, S2, S3, S4) während der jeweiligen Zeitspanne (t1, t2, t3, t4) getestet wird und bei Fehlfunktion zumindest eines Schalters (S1, S2, S3, S4) ein Fehlersignal (F) generiert wird.

2. Verfahren nach Anspruch 1, **dadurch gekennzeichnet, dass** ein erstes Potential eines zwischen dem ersten und zweiten Schalter (S1, S2) befindlichen ersten Testpunkts (P1) geprüft wird und ein zweites Potential eines zwischen dem dritten und vierten Schalter (S1, S2) befindlichen zweiten Testpunkts (P2) geprüft wird und damit auf eine Fehlfunktion zumindest eines Schalters (S1, S2, S3, S4) geschlossen wird.

3. Verfahren nach Anspruch 2, **dadurch gekennzeichnet, dass** das erste Potential während der ersten Zeitspanne (t1) und/oder der zweiten Zeitspanne (t2) geprüft wird und das zweite Potential während der dritten Zeitspanne (t3) und/oder der vierten Zeitspanne (t4) geprüft wird.

4. Verfahren nach Anspruch 3, **dadurch gekennzeichnet, dass** jeweils die erste und zweite Zeitspanne (t1, t2) zumindest teilweise überlappen und die dritte und vierte Zeitspanne (t3, t4) zumindest teilweise überlappen **und dass** das erste Potential während dem Überlappen der ersten und zweiten Zeitspanne (t1, t2) geprüft wird und das zweite Potential während dem Überlappen der dritten und vierten Zeitspanne (t3, t4) geprüft wird.

5. Verfahren nach Anspruch 4, **dadurch gekennzeichnet, dass** während dem Überlappen der ersten und zweiten Zeitspanne (t1, t2) das erste Potential mit dem zweiten Potential verglichen wird, **und dass** während dem Überlappen der dritten und vierten Zeitspanne (t3, t4) das zweite Potential mit dem ersten Potential verglichen wird

6. Verfahren nach Anspruch 4 oder 5, **dadurch gekennzeichnet, dass** der erste Testpunkt (P1) während dem Überlappen der ersten und zweiten Zeitspanne (t1, t2) auf Potentialfreiheit geprüft wird und der zweite Testpunkt (P2) während dem Überlappen der dritten und vierten Zeitspanne (t3, t4) auf Potentialfreiheit geprüft wird.

7. Verfahren nach einem der Ansprüche 1 bis 6, **dadurch gekennzeichnet, dass** bei Generierung eines Fehlersignals (F) die Schalter (S1, S2, S3, S4) zum Öffnen angesteuert werden.

8. Verfahren nach einem der Ansprüche 1 bis 7, **dadurch gekennzeichnet, dass** die Schalter (S1, S2, S3, S4) bei Empfang eines Sperrsignals (N) zum Öffnen angesteuert werden.

9. Verfahren nach Anspruch 8, **dadurch gekennzeichnet, dass** das Sperrsignal (N) in ein oszillierendes Signal gewandelt und anschließend gleichgerichtet wird.

10. Schaltvorrichtung (1) zum Schalten eines Signals (S) auf einer Verbindung zwischen einem ersten Punkt (A) und einem zweiten Punkt (B), die Schaltvorrichtung (1) **dadurch gekennzeichnet, dass** zwischen dem ersten Punkt (A) und dem zweiten Punkt (B) ein erster Zweig (Z1) mit einem ersten Schalter (S1) und einem seriellen zweiten Schalter (S2) angeordnet ist, und parallel zum ersten Zweig (Z1) ein zweiter Zweig (Z2) mit einem dritten Schalter (S3) und einem seriellen vierten Schalter (S4) angeordnet ist, **dass** zumindest eine Steuereinheit (2) vorgesehen ist, die mit den Schaltern (S1, S2, S3, S4) verbunden ist und ausgestaltet ist diese mittels Steuersignalen (x1, x2, x3, x4) anzusteuern, **dass** eine Testeinrichtung (3) vorgesehen ist, die mit der zumindest einen Steuereinheit (2) verbunden ist und ausgestaltet ist die zumindest eine Steuereinheit (2) anzuweisen in einer Testsequenz (T) den ersten Schalter (S1) für eine erste Zeitspanne (t1) zu öffnen und zu wieder zu schließen, den zweiten Schalter (S2) für eine zweite Zeitspanne (t2) zu öffnen und wieder zu schließen, den dritten Schalter (S3) für eine dritte Zeitspanne (t3) zu öffnen und wieder zu schließen, und den vierten Schalter (S4) für eine vierte Zeitspanne (t4) zu öffnen und wieder zu schließen, wobei weder die erste, noch die zweite Zeitspanne (t1, t2) mit der dritten oder vierten Zeitspanne (t3, t4) überlappen **und dass** zumindest eine Prüfeinheit (4) vorgesehen ist, die ausgestaltet ist die Funktion der Schalter (S1, S2, S3, S4) während der jeweiligen Zeitspanne (t1, t2, t3, t4) zu prüfen und bei einer Fehlfunktion zumindest eines Schalters (S1, S2, S3, S4) ein Fehlersignal (F) zu generieren.

11. Schaltvorrichtung (1) nach Anspruch 10, **dadurch gekennzeichnet, dass** die zumindest eine Prüfeinheit (4) mit der Steuereinheit (2) verbunden ist und ausgestaltet ist bei Generierung eines Fehlersignals (F) die Steuereinheit (2) anzuweisen die Schalter (S1, S2, S3, S4) zum Öffnen anzusteuern.

12. Schaltvorrichtung (1) nach Anspruch 11, **dadurch gekennzeichnet, dass** zumindest ein Sperreingang (N_in) vorgesehen ist, der ausgestaltet ist bei Anliegen eines Sperrsignals (N) die Schalter (S1, S2, S3, S4) zum Öffnen anzusteuern.

13. Schaltvorrichtung (1) nach Anspruch 12, **dadurch gekennzeichnet, dass** der zumindest eine Sperreingang (N_in) mit der zumindest einen Steuereinheit (2) verbunden ist und ausgestaltet ist diese bei Anliegen eines Sperrsignals (N) anzuweisen die Schalter (S1, S2, S3, S4) zum Öffnen anzusteuern.

14. Schaltvorrichtung (1) nach Anspruch 12, **dadurch gekennzeichnet, dass** der zumindest eine Sperreingang (N_in) über eine Gleichrichterschaltung (6) mit der Steuereinheit (2) verbunden ist, wobei die Gleichrichterschaltung (6) ausgestaltet ist das Sperrsignal (N) in ein oszillierendes Signal zu wandeln und gleichzurichten.

15. Verwendung einer Schaltvorrichtung nach einem der Ansprüche 10 bis 14 zum Abschalten einer Versorgungsspannung einer Treiberschaltung (Dr) einer Brückenschaltung (HB) und/oder eines der Treiberschaltung (Dr) zugeführten PWM-Signals (PWM_{h,l}) eines Langstatorlinearmotors oder eines rotativen Motors.

## Claims

1. A method for switching a signal (S) on a connection between a first point (A) and a second point (B), the method being **characterized in that:** the signal (S) is passed through a first switch (S1) and a serial second switch (S2) in a first branch (Z1) connecting the first point (A) and the second point (B), and the signal (S) is passed through a third switch (S3) and a serial fourth switch (S4) in a second branch (Z2) that is parallel to the first branch (Z1) and connects the first point (A) and the second point (B); **that** in a test sequence (T), the first switch (S1) is opened for a first period of time (t1), and closed again, the second switch (S2) is opened for a second period of time (t2) and closed again, the third switch (S3) is opened for a third period of time (t3) and closed again, and the fourth switch (S4) is opened for a fourth period of time (t4) and closed again, wherein neither the first nor second period of time (t1, t2) overlaps with the third or fourth period of time (t3, t4); and **that** the functioning of the switches (S1, S2, S3, S4) is tested during the respective period of time (t1, t2, t3, t4), and an error signal (F) is generated in the event of a malfunction of at least one switch (S1, S2, S3, S4).

2. The method according to claim 1, **characterized in that** a first potential of a first test point (P1) located between the first and second switches (S1, S2) is tested, and a second potential of a second test point (P2) located between the third and fourth switches (S1, S2) is tested, and a determination regarding malfunctioning of at least one switch (S1, S2, S3, S4) is made therewith.

3. The method according to claim 2, **characterized in that** the first potential is tested during the first period of time (t1) and/or the second period of time (t2), and the second potential is tested during the third period of time (t3) and/or the fourth period of time (t4).

4. The method according to claim 3, **characterized in that** the first and second period of time (t1, t2) overlap at least partially, and the third and fourth period of time (t3, t4), respectively, overlap at least partially, **and that** the first potential is tested during the overlapping of the first and second periods of time (t1, t2), and the second potential is tested during the overlapping of the third and fourth periods of time (t3, t4).

5. The method according to claim 4, **characterized in that** the first potential is compared with the second potential during the overlapping of the first and second periods of time (t1, t2), **and that** the second potential is compared with the first potential during the overlapping of the third and fourth periods of time (t3, t4).

6. The method according to claim 4 or 5, **characterized in that** testing is performed for whether the first test point (P1) has zero potential during the overlapping of the first and second periods of time (t1, t2), and for whether the second test point (P2) has zero potential during the overlapping of the third and fourth periods of time (t3, t4).

7. The method according to any of claims 1 to 6, **characterized in that** the switches (S1, S2, S3, S4) are controlled to open when an error signal (F) is generated.

8. The method according to any of claims 1 to 7, **characterized in that** the switches (S1, S2, S3, S4) are controlled to open when an inhibit signal (N) is received.

9. The method according to claim 8, **characterized in that** the inhibit signal (N) is converted into an oscillating signal and then rectified.

10. A switching device (1) for switching a signal (S) on a connection between a first point (A) and a second point (B), the switching device being **characterized in that:** a first branch (Z1) having a first switch (S1) and a serial second switch (S2) is arranged between the first point (A) and the second point (B), and a second branch (Z2) having a third switch (S3) and a serial fourth switch (S4) is arranged parallel to the first branch (Z1); that at least one control unit (2), which is connected to the switches (S1, S2, S3, S4) and is configured to control same by means of control signals (x1, x2, x3, x4), is provided; **that** there is provided a testing device (3) that is connected to the at least one control unit(2) and is configured to instruct the at least one control unit (2), in a test sequence (T), to open the first switch (S1) for a first period of time (t1) and then close same again, open the second switch (S2) for a second period of time (t2) and then close same again, open the third switch (S3) for a third period of time (t3) and then close same again, and open the fourth switch (S4) for a fourth period of time (t4) and then close same again, wherein neither the first period of time nor the second period of time (t1, t2) overlaps with the third or fourth period of time (t3, t4); **and that** there is provided is at least one testing unit (4) configured to test the functioning of the switches (S1, S2, S3, S4) during the respective periods of time (t1, t2, t3, t4), and to generate an error signal (F) in the event of a malfunction of at least one switch (S1, S2, S3, S4).

11. The switching device (1) according to claim 10, **characterized in that** the at least one testing unit (4) is connected to the control unit (2) and configured to instruct the control unit (2) to control the switches (S1, S2, S3, S4) to open when an error signal (F) has been generated.

12. The switching device (1) according to claim 11, **characterized in that** there is provided at least one inhibiting input (F_in) that is configured to control the switches (S1, S2, S3, S4) to open when an inhibit signal (N) is applied.

13. The switching device (1) according to claim 12, **characterized in that** the at least one inhibiting input (F_in) is connected to the at least one control unit (2) and configured to instruct same to control the switches (S1, S2, S3, S4) to open when an inhibit signal (N) is applied.

14. The switching device (1) according to claim 12, **characterized in that** the at least one inhibiting input (N_in) is connected via a rectifier circuit (6) to the at least one control unit (2), wherein the rectifier circuit (6) is configured in order to convert the inhibit signal (N) into an oscillating signal and rectify it.

15. Use of the switching device according to any of claims 10 to 14 to switch off a supply voltage of a driver circuit (Dr) of a bridge circuit (HB) and/or a PWM signal (PWM_{h,l}) of a long-stator linear motor or rotary motor that is supplied to the driver circuit (Dr).

## Revendications

1. Procédé permettant de commuter un signal (S) sur une connexion entre un premier point (A) et un second point (B), **caractérisé en ce que** le signal (S) est dirigé dans une première branche (Z1) reliant le premier point (A) et le second point (B) par l'intermédiaire d'un premier commutateur (S1) et d'un deuxième commutateur série (S2), et le signal (S) est dirigé dans une seconde branche (Z2) parallèle à la première branche (Z1) et reliant le premier point (A) et le second point (B) par l'intermédiaire d'un troisième commutateur (S3) et d'un quatrième commutateur série (S4), **en ce que,** dans une séquence de test (T), le premier commutateur (S1) est ouvert et refermé pendant une première période de temps (t1), le deuxième commutateur (S2) est ouvert et refermé pendant une deuxième période de temps (t2), le troisième commutateur (S3) est ouvert et refermé pendant une troisième période de temps (t3), et le quatrième commutateur (S4) est ouvert et refermé pendant une quatrième période de temps (t4), ni la première ni la deuxième période de temps (t1, t2) ne chevauchant la troisième ou la quatrième période de temps (t3, t4), **en ce que** le fonctionnement des commutateurs (S1, S2, S3, S4) est testé pendant la période de temps respective (t1, t2, t3, t4), et un signal d'erreur (F) est généré en cas de dysfonctionnement d'au moins un commutateur (S1, S2, S3, S4).

2. Procédé selon la revendication 1, **caractérisé en ce qu'un** premier potentiel d'un premier point de test (P1) situé entre les premier et deuxième commutateurs (S1, S2) est vérifié, et un second potentiel d'un second point de test (P2) situé entre les troisième et quatrième commutateurs (S1, S2) est vérifié, et un dysfonctionnement d'au moins un commutateur (S1, S2, S3, S4) est ainsi déduit.

3. Procédé selon la revendication 2, **caractérisé en ce que** le premier potentiel est vérifié pendant la première période de temps (t1) et/ou la deuxième période de temps (t2), et le second potentiel est vérifié pendant la troisième période de temps (t3) et/ou la quatrième période de temps (t4).

4. Procédé selon la revendication 3, **caractérisé en ce que** les première et deuxième périodes de temps (t1, t2) se chevauchent au moins partiellement et les troisième et quatrième périodes de temps (t3, t4) se chevauchent au moins partiellement, **et en ce que** le premier potentiel est vérifié pendant le chevauchement des première et deuxième périodes de temps (t1, t2), et le second potentiel est vérifié pendant le chevauchement des troisième et quatrième périodes de temps (t3, t4).

5. Procédé selon la revendication 4, **caractérisé en ce que,** pendant le chevauchement des première et deuxième périodes de temps (t1, t2), le premier potentiel est comparé au second potentiel, **et en ce que,** pendant le chevauchement des troisième et quatrième périodes de temps (t3, t4), le second potentiel est comparé au premier potentiel.

6. Procédé selon la revendication 4 ou 5, **caractérisé en ce que** la liberté de potentiel du premier point de test (P1) est vérifiée pendant le chevauchement des première et deuxième périodes de temps (t1, t2), et la liberté de potentiel du second point de test (P2) est vérifiée pendant le chevauchement des troisième et quatrième périodes de temps (t3, t4).

7. Procédé selon l'une des revendications 1 à 6, **caractérisé en ce que,** lorsqu'un signal d'erreur (F) est généré, l'ouverture des commutateurs (S1, S2, S3, S4) est activée.

8. Procédé selon l'une des revendications 1 à 7, **caractérisé en ce que,** lorsqu'un signal de blocage (N) est reçu, l'ouverture des commutateurs (S1, S2, S3, S4) est activée.

9. Procédé selon la revendication 8, **caractérisé en ce que** le signal de blocage (N) est converti en un signal oscillant puis redressé.

10. Dispositif de commutation (1) permettant de commuter un signal (S) sur une connexion entre un premier point (A) et un second point (B), le dispositif de commutation (1) étant caractérisé en ce **qu**'une première branche (Z1) comportant un premier commutateur (S1) et un deuxième commutateur série (S2) est disposée entre le premier point (A) et le second point (B), et une seconde branche (Z2), parallèle à la première branche (Z1), comportant un troisième commutateur (S3) et un quatrième commutateur série (S4), est disposée, **en ce qu**'au moins une unité de commande (2) est prévue, laquelle est connectée aux commutateurs (S1, S2, S3, S4) et est configurée pour commander ceux-ci au moyen de signaux de commande (x1, x2, x3, x4), **en ce qu**'un équipement de test (3) est prévu, lequel est connecté à l'au moins une unité de commande (2) et est configuré pour ordonner à l'au moins une unité de commande (2), dans une séquence de test (T), d'ouvrir et de refermer le premier commutateur (S1) pendant une première période de temps (t1), d'ouvrir et de refermer le deuxième commutateur (S2) pendant une deuxième période de temps (t2), d'ouvrir et de refermer le troisième commutateur (S3) pendant une troisième période de temps (t3), et d'ouvrir et de refermer le quatrième commutateur (S4) pendant une quatrième période de temps (t4), ni la première ni la deuxième période de temps (t1, t2) ne chevauchant la troisième ou la quatrième période de temps (t3, t4), et **en ce qu**'au moins une unité de vérification (4) est prévue, laquelle est configurée pour vérifier le fonctionnement des commutateurs (S1, S2, S3, S4) pendant la période de temps respective (t1, t2, t3, t4) et pour générer un signal d'erreur (F) en cas de dysfonctionnement d'au moins un commutateur (S1, S2, S3, S4).

11. Dispositif de commutation (1) selon la revendication 10, **caractérisé en ce que** l'au moins une unité de vérification (4) est connectée à l'unité de commande (2) et est configurée pour ordonner à l'unité de commande (2) d'activer l'ouverture des commutateurs (S1, S2, S3, S4) lorsqu'un signal d'erreur (F) est généré.

12. Dispositif de commutation (1) selon la revendication 11, **caractérisé en ce qu**'au moins une entrée de blocage (N_in) est prévue, laquelle est configurée pour activer l'ouverture des commutateurs (S1, S2, S3, S4) en présence d'un signal de blocage (N).

13. Dispositif de commutation (1) selon la revendication 12, **caractérisé en ce que** l'au moins une entrée de blocage (N_in) est connectée à l'au moins une unité de commande (2) et est configurée pour ordonner à celle-ci d'activer l'ouverture des commutateurs (S1, S2, S3, S4) en présence d'un signal de blocage (N).

14. Dispositif de commutation (1) selon la revendication 12, **caractérisé en ce que** l'au moins une entrée de blocage (N_in) est connectée à l'unité de commande (2) par l'intermédiaire d'un circuit redresseur (6), le circuit redresseur (6) étant configuré pour convertir le signal de blocage (N) en un signal oscillant et pour le redresser.

15. Utilisation d'un dispositif de commutation selon l'une des revendications 10 à 14, pour couper une tension d'alimentation d'un circuit d'attaque (Dr) d'un circuit en pont (HB) et/ou un signal PWM (PVVM_{h,l}), appliqué au circuit d'attaque (Dr), d'un moteur linéaire à stator long ou d'un moteur rotatif.
